# FASCICULE DE BREVET EUROPEEN

(11) **EP 1 903 492 B1**
(45) Date de publication et mention de la délivrance du brevet: **21.03.2012**
(21) Numéro de dépôt: 07352004.1
(22) Date de dépôt: 11.09.2007
(51) Int. Cl.: G06Q 30/00, B60S 5/02

(54) **Caisson de protection ventile et/ou enseigne pour publicité numérique et/ou informative pouvant éventuellement être sonore pour les distributeurs d'essences des stations services.**
Belüftetes Schutzgehäuse und/oder numerisches und/oder informatives Werbeschild, das für Zapfsäulen von Tankstellen mit einem akustischen Signal versehen sein kann
Ventilated safety caisson and/or sign for digital and/or informative advertising which can include sound for petrol station petrol dispensers.

(30) Priorité: 15.09.2006 FR 0608069
(43) Date de publication de la demande: 26.03.2008
(73) Titulaire: Padulo, Robert, AD500 Andorre la Vielle (AD)
(72) Inventeur: Padulo, Robert, AD500 Andorre la Vielle (AD)

(56) Documents cités:
- WO-A1-2007/116116
- US-A- 5 867 403
- US-A- 6 052 629
- US-A- 6 152 591

## Description

La présente invention comprend un caisson de sécurité ventilé et/ou une ou plusieurs unités d'affichage vidéo pour commercialiser un espace publicitaire numérique et/ou informatif pouvant éventuellement être sonores sur les distributeurs d'essences des stations services.

La publicité dans les stations services est traditionnellement effectuée par un affichage fixe en papier ou un affichage rotatif à durée constante en papier de type urbain ou autoroutier.

Pour utiliser des publicités numériques sur des distributeurs d'essences des stations services, il faut résoudre différents problèmes techniques. Le premier est de protéger le matériel utilisé contre des intempéries, vol ou dégradations, le second problème technique est que l'on puisse ventiler le matériel protégé et le troisième problème est de stocker les publicités numériques ou informations, de gestionner les temps d'apparition changeant des publicités numériques et de commander simultanément ou éventuellement indépendamment les différentes unités d'affichage vidéo. Le quatrième problème est la fixation sur les distributeurs d'essences du fait de leurs différentes formes et de l'emplacement du dispositif.

Le document DE8805707U divulgue un caisson monté sur un distributeur d'essence et comprenant deux écrans où les écrans sont utilisés pour afficher des publicités.

Les documents US6152591A et US6052629A divulguent des distributeurs d'essence comprenant des écrans qui peuvent afficher des publicités.

Le document WO2007/116116A divulgue un caisson de protection pour des unités d'affichage vidéo.

Le dispositif selon l'invention permet l'utilisation de publicités numériques ou informatives pouvant éventuellement être sonores pour les distributeurs d'essences des stations services. Il comporte un caisson de protection ventilé pour les unités d'affichage vidéo qui comprend un bâti verrouillable ventilé avec des vitres de sécurités comprenant des joints étanches dans lequel il y a une ou plusieurs unités d'affichage vidéo pour commercialiser un espace publicitaire numérique ou informatif, ainsi qu'un processeur informatique.

Le caisson de protection ventilé est caractérisé par des orifices de ventilation qui permettent éventuellement aider par un ventilateur logé dans le bâti la ventilation des unités d'affichage vidéo, ainsi que le processeur informatique, en les protégeant des intempéries, vol ou dégradation.

Le processeur informatique est caractérisé par la mémoire qui lui permet d'enregistrer différentes publicités numériques ou informations et du son numérique.

Le processeur informatique est caractérisé par la gestion des durées changeantes ou éventuellement fixe des différentes publicités numériques ou informations.

Le processeur informatique est caractérisé par le commandement des différentes unités d'affichage vidéo simultanément, ou éventuellement indépendamment. Le caisson est caractérisé par la fixation permettant de s'adapter aux différentes formes des distributeurs d'essences pouvant se positionner de la façon recherchée.

Dans le mode de réalisation avantageux, on a recours à l'une et/ou à l'autre des dispositions suivantes.

Le caisson de sécurité ventilé est constitué du bâti (1), des vitres de sécurité (2), du couvercle (4), du gond ou charnière (11) et de la serrure (3).

Le bâti (1) en forme de parallélépipède, avec une ou plusieurs vitres de sécurités (2) comprenant des joints étanches (non représentés). Les vitres de sécurités (2) sont situées sur les faces perpendiculaires au couvercle (4). Le couvercle (4) est lié au bâti (1) par un gond ou charnière (11). Le couvercle (4) est perforé par divers orifices (9) qui permette la fixation du caisson de sécurité ventilé aux distributeurs d'essences, le trou (10) permet le passage du câble d'alimentation (non représenté). Le couvercle (4) et le bâti (1) sont fermés par une serrure (3).

Les orifices de ventilation (6) sont situés en haut et en bas du bâti (1). Derrière les orifices de ventilation (6) sont situés les systèmes d'évacuation d'eau (13).

A l'intérieur du bâti (1) sont fixés les unités d'affichage vidéo (5) ainsi que, le processeur informatique (7) et éventuellement le ventilateur (12). Les câbles (8) permettent la connexion et l'alimentation des différents matériels utilisés.

L'invention sera mieux comprise à la lecture de la description de modes de réalisation données ci-après à titre d'exemple non limitatifs. La description se réfère aux dessins qui l'accompagnent dans lesquels :

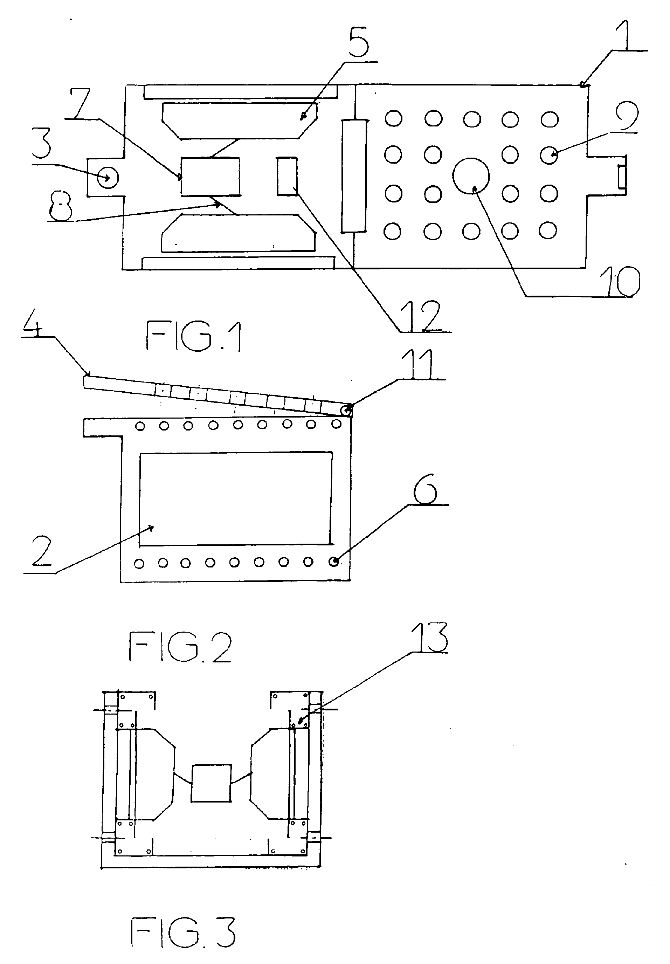

La figure 1 représente la vue de dessus du dispositif de l'invention.
La figure 2 représente la vue de face du dispositif de l'invention.
La figure 3 représente la vue en coupe du dispositif de l'invention.

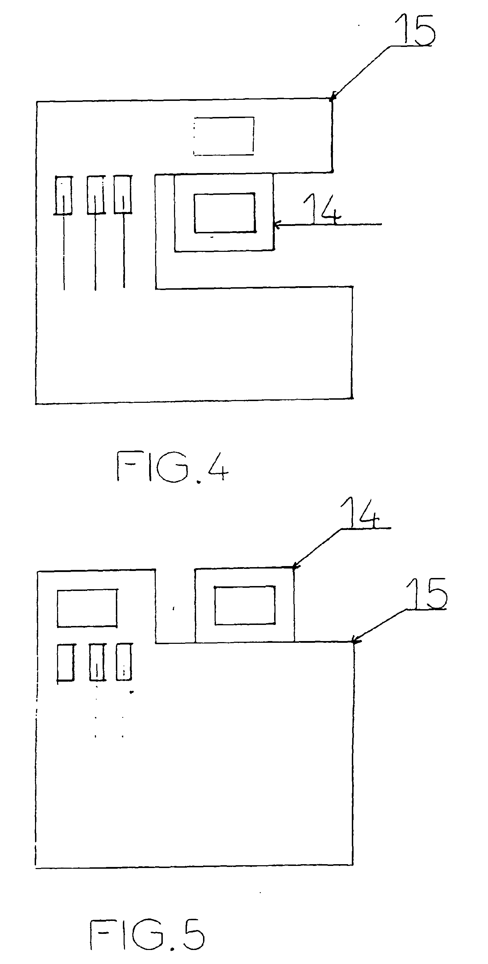

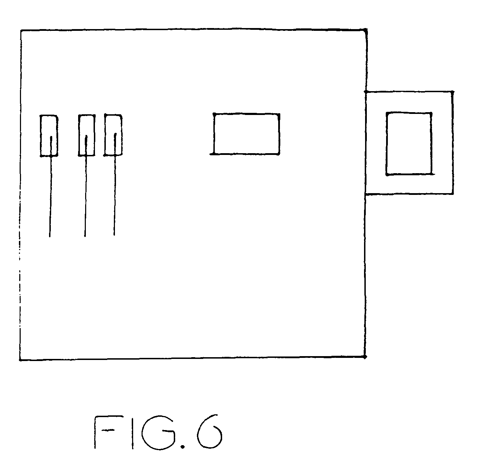

Les figures 4,5,6 montrent, quant à elles, le caisson de protection ventilé (14) dans son environnement préféré, à savoir fixer sur les distributeurs d'essences (15).

Ses dimensions, son application, sa façon d'être implanté et de ne pas gêner tout en apportant un espace publicitaire numérique, et d'information pouvant être sonore. Comme il va de soit et comme il en résulte également de ce qui précède, la présente invention n'est pas limitée aux modes de réalisation plus particulièrement décrits. Elle en embrasse au contraire toute les variantes et notamment celle ou les enseignes présentent une forme différente de celle plus particulièrement décrites.

## Revendications

1. Caisson de protection (14) comportant plusieurs unités d'affichage vidéo (5) pour commercialiser un espace publicitaire numérique ou informatif apte à être fixé sur les distributeurs d'essence des stations services (15), le caisson comprenant un bâti en forme parallélépipède (1) verrouillable ventilé avec des vitres de sécurité (2) à joints étanches et un couvercle perforé, les unités d'affichage vidéo étant montées dos à dos en regard des vitres de sécurité, et comportant un processeur informatique, où les vitres de sécurité sont situées sur les faces perpendiculaires au couvercle et le bâti (1) verrouillable peut être fixé aux différentes formes de distributeurs d'essence (15), au moyen des divers orifices (9) formés sur le couvercle (4).

2. Caisson de protection (14) selon la revendication 1 **caractérisé en ce qu'**il présente des orifices de ventilation (6) qui permettent par un ventilateur (12) logé dans le bâti (1), la ventilation des unités d'affichage vidéo (5) ainsi que du processeur informatique (7), en les protégeant des intempéries, vol ou dégradation.

3. Caisson de protection (14) selon la revendication 1 **caractérisé en ce qu'**il comprend un système d'évacuation d'eau (13) situé derrière les orifices de ventilation (6).

4. Caisson de protection (14) selon la revendication 1 **caractérisé en ce qu'**il comprend un processeur informatique (7) qui lui permet d'enregistrer différentes publicités numériques ou informations et du son numérique.

## Claims

1. A protective casing (14) for video display units (5) for marketing a digital advertising or informative space suitable for fixing on service station petrol dispensers . (15), the casing comprising a frame in the form of a ventilated lockable parallelepiped (1) with security glass (2), waterproof joints and a perforated cover, the video display units being fitted back to back with the security glass, and comprising a computer processor, where the security glasses are located on the faces perpendicular to the cover and the lockable frame (1) can be fixed to the various models of petrol dispensers (15), by means of various orifices (9) formed on the cover (4).

2. Protective casing (14) according to claim 1 **characterised in that** it has orifices for ventilation (6) which allow through the use of a fan (12) installed in the frame (1), ventilation of the video display units (5) and the computer processor (7), in protecting them from weather, theft or deterioration.

3. Protective casing (14) according to claim 1 **characterised by** comprising a system for the drainage of water (13) placed behind the ventilation orifices (6).

4. Protective casing (14) according to claim 1 **characterised in that** it comprises a computer processor (7) enabling it to record different digital advertisements or information and digital sound.

## Patentansprüche

1. Schutzkastenwagen ( 14 ) fiir die Einheiten von Videoanschlag ( 5 ) um eine numerische oder informative Reklamefläche auf den Markt zu bringen, die fähig ist, an den Tanksäulen der Kundendienstwerkstätten ( 15 ) befestigt zu sein, der ein Stativ in Form Quaders ( 1 ) einschließende Kastenwagen, der ist verrouillable, mit Sicherheitsfensterscheiben ( 2 ) in wasserdichten Gelenken und einem perforierten Deckel belüftet, die Einheiten von Videoanschlag, die Rücken in Rücken im Vergleich zu den Sicherheitsfensterscheiben gehoben sind, und einen Informationsprozessor verstehend(einschließend), wo Sicherheitsfensterscheiben auf den zum Deckel senkrechten Gesichtern gelegt sind und das Stativ ( 1 ) verrouillable kann in den unterschiedlichen Formen von Tanksäulen ( 15 ), mit Hilfe der verschiedenen Öffnungen (9) Gebildete auf dem Deckel (4) festgelegt sein.

2. Schutzkastenwagen (14 ) nach der Anforderung 1 Charakterisiertes darin, was er Lüftungsöffnungen ( 6 ) vorstellt, die von einem im Stativ ( 1 ) untergebrachten Ventilator ( 12 ) die Lüf.

3. Schutzkastenwagen ( 14 ) nach der Anforderung 1 Charakterisiertes darin, was er einen gelegten Wasserablauf ( 13 ) hinter den Lüftungsöffnungen ( 6 ) versteht.

4. erlaubt Schutzkastenwagen ( 14 ) nach der Anforderung 1 Charakterisiertes darin, was er einen Informationsprozessor d ( 7 ) versteht, ihm, unterschiedliche numerische Anzeigen(Werbungen) oder Informationen und des numerischen seines aufzunehmen.tung der Einheiten von Videoanschlag ( 5 ) erlauben sowie vom Prozessor
